# EUROPEAN PATENT APPLICATION

(11) **EP 1 927 878 A1**
(43) Date of publication of application: **04.06.2008**
(21) Application number: 07121802.8
(22) Date of filing: 28.11.2007
(51) Int. Cl.: G02B 26/08, B81B 3/00

(54) **Simplified manufacturing process for micro mirrors**

(30) Priority: 28.11.2006 US 564040
(71) Applicant: Spatial Photonics, Inc., Sunnyvale, CA 94086 (US)
(72) Inventor: Pan, Shaoher X., San Jose, CA 95120 (US)
(74) Representative: Epping - Hermann - Fischer

(57) **Abstract**

A micro mirror includes a hinge support post on the substrate, a hinge connection post on the hinge support post, wherein the hinge connection post comprises a bottom layer connected to the hinge support post and a side layer surrounding a cavity in the center of the hinge connection post, a hinge component connected to the side layer of the hinge connection post; and a mirror plate configured to tilt around the hinge component.

## Description

### Background

The present disclosure relates to the fabrication of micro mirrors.

This patent application claims the priority of the US patent application 11/564,040, the disclosure content of which is hereby incorporated by reference.

A spatial light modulator (SLM) can be built with an array of tiltable mirror plates having reflective surfaces. Each mirror plate can be tilted about an axis by electrostatic forces to an "on" position and an "off' position. The electrostatic forces can be generated by electric potential differences between the mirror plate and an electrode underneath the mirror plate. In the "on" position, the micro mirror plate can reflect incident light to form an assigned pixel in a display image. In the "off" position, the micro mirror plate can direct incident light away from the display image. A mirror plate can be held by a mechanical stop at the "on" or the "off" position.

### Summary

In one general aspect, the present invention relates to a micro mirror including a hinge connection post supported by the substrate, wherein the hinge connection post comprises a bottom layer connected to the hinge support post and a side layer surrounding a cavity in the center of the hinge connection post; a hinge component connected to the side layer of the hinge connection post; and a mirror plate configured to tilt around the hinge component.

In another general aspect, the present invention relates to a method for fabricating a mirror plate over a substrate. The method includes forming a hinge support post on the substrate; simultaneously forming a hinge connection post on the hinge support post and a hinge layer connected to the hinge connection post; forming a reflective layer on the spacer layer; and selectively removing portions of the reflective layer and the hinge layer to form the mirror plate and a hinge component connected to the hinge connection post and the hinge layer, wherein the mirror plate is configured to tilt around the hinge component.

In another general aspect, the present invention relates to a method for fabricating a mirror plate over a substrate. The method includes forming a hinge support post on the substrate; disposing a sacrificial material on the substrate and the hinge support post; forming a via in the sacrificial material to expose an upper surface of the hinge support post; depositing an electrically conductive material to simultaneously form a hinge connection post in the via and a hinge layer on the sacrificial material; selectively removing the electrically conductive material in the hinge layer to form openings in the hinge layer to define a hinge in the hinge layer and over the hinge connection post; forming a spacer layer on the hinge layer and the hinge; forming a reflective layer on the spacer layer; removing portions of the reflective layer, the spacer layer and the hinge layer to expose the sacrificial material; and removing the sacrificial material to form the mirror plate and the hinge connected to the hinge connection post and the hinge layer, wherein the mirror plate is configured to tilt around the hinge component.

Implementations of the system may include one or more of the following. The side layer can be cone shaped. The side layer and the bottom layer can form a cup-like structure. The side layer, the bottom layer and the hinge component can form a unitary structure. The side layer, the bottom layer and the hinge component can be made of substantially the same material. The side layer can be substantially vertical to the substrate. The mirror plate can include a reflective layer and a hinge layer. The hinge connection post, the hinge component and the hinge layer can form a unitary structure. The hinge component and the hinge layer can form a co-planar structure. The hinge connection post, the hinge component and the hinge layer can be made of substantially the same material. The hinge connection post, the hinge component and the hinge layer can include an electrically conductive material.

Implementations may include one or more of the following advantages. The disclosed system and methods can provide a simplified process for fabricating micro mirrors on a substrate and improved mechanical integrity and the strength of the micro mirrors. Several components of the mirror plate and support structure can be simultaneously formed in a unitary component and in a single step.

Although the invention has been particularly shown and described with reference to multiple embodiments, it will be understood by persons skilled in the relevant art that various changes in form and details can be made therein without departing from the spirit and scope of the invention.

### Brief Description of the Drawings

The following drawings, which are incorporated in and form a part of the specification, illustrate embodiments of the present invention and, together with the description, serve to explain the principles of the invention.

FIG. 1 illustrates an expanded view of a micro mirror.

FIG. 2 is a bottom view of the mirror plate of the micro mirror of FIG. 1.

FIG. 3 illustrates a detailed view of a hinge, a hinge connection post and a hinge support post in the micro mirror of FIG. 1.

FIG. 4 illustrates a process flow diagram for fabricating the micro-mirror.

FIGS. 5-8 are cross-sectional views along line A-A of FIG. 2 showing several steps of fabricating the micro mirror on a substrate.

FIGS. 9-12 are cross-sectional views along line B-B of FIG. 2 showing several steps of fabricating the micro mirror on a substrate.

FIGS. 13-14 are cross-sectional views along line A-A of FIG. 2 showing several steps of fabricating the micro mirror on a substrate.

FIGS. 15, 16, 17A, 18A, 19A and 20A are cross-sectional views along line C-C of FIG. 2 showing several steps of fabricating the micro mirror on a substrate.

FIGS. 17B, 18B, 19B and 20B are cross-sectional views along line A-A of FIG. 2 showing several steps of fabricating the micro mirror on a substrate.

FIGS. 21 and 22 are cross-sectional views along the lines C-C and A-A, respectively, of FIG. 2 showing the micro mirror formed on the substrate.

### Detailed description

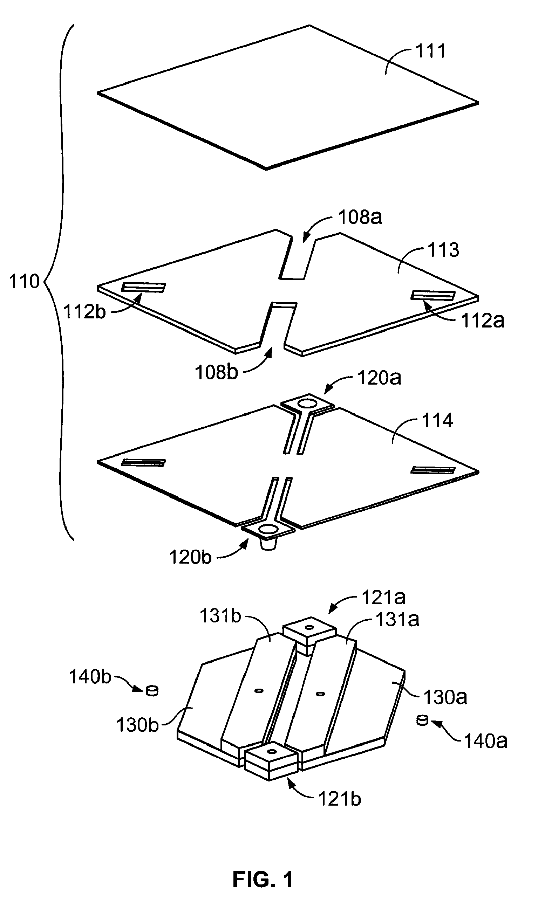

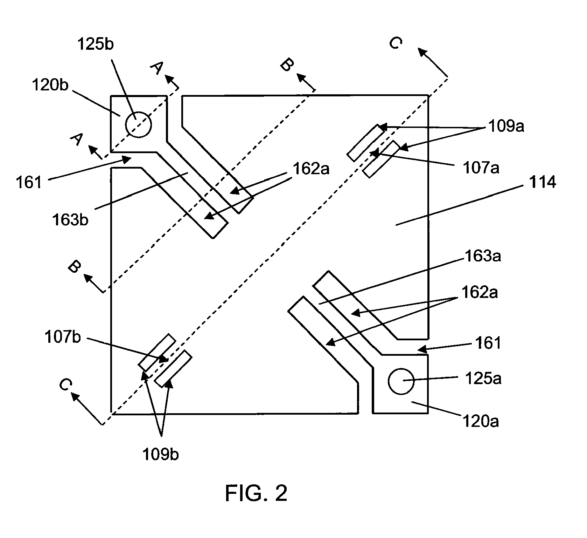

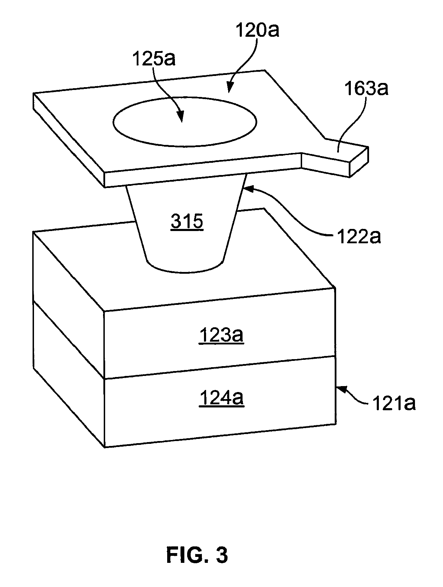

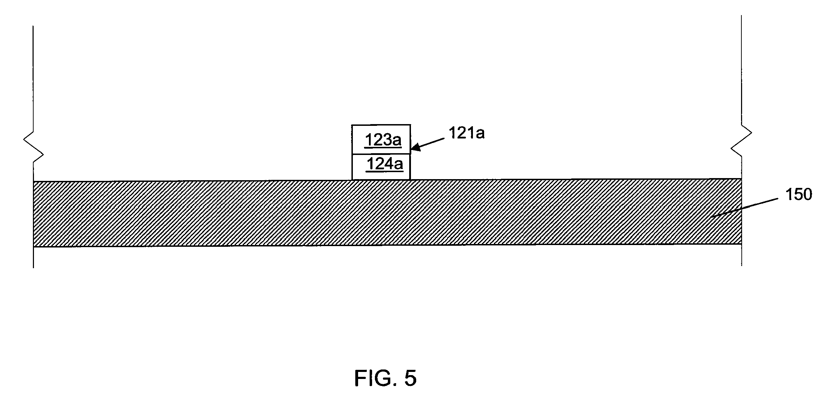

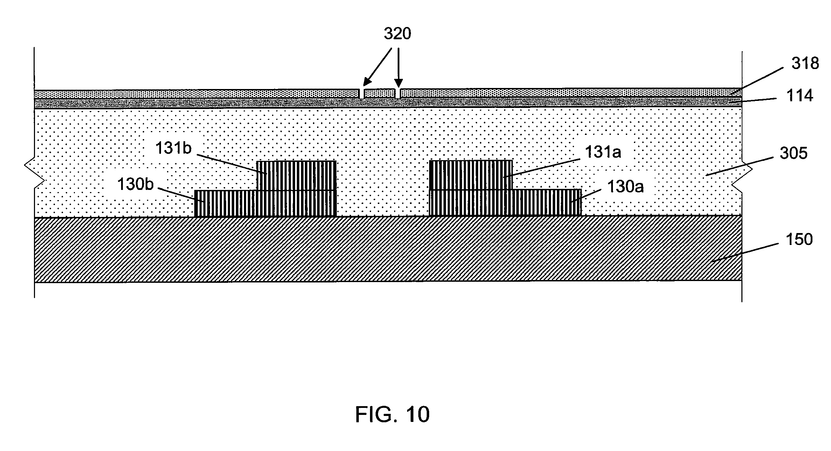

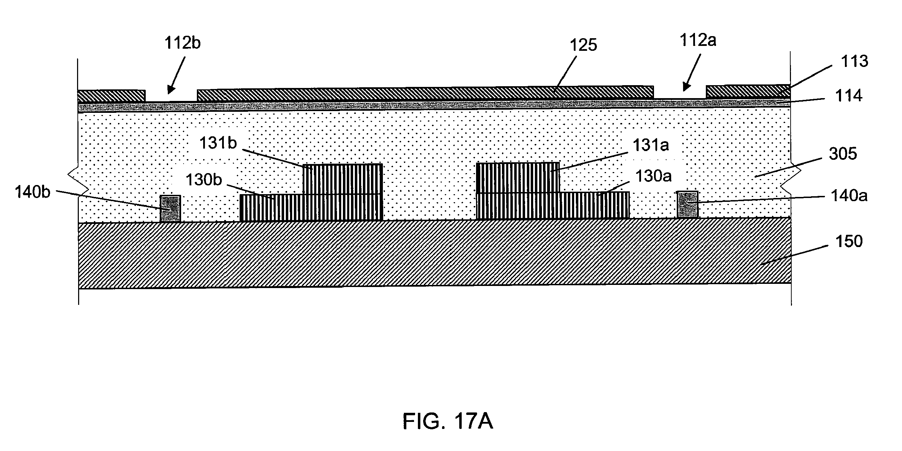

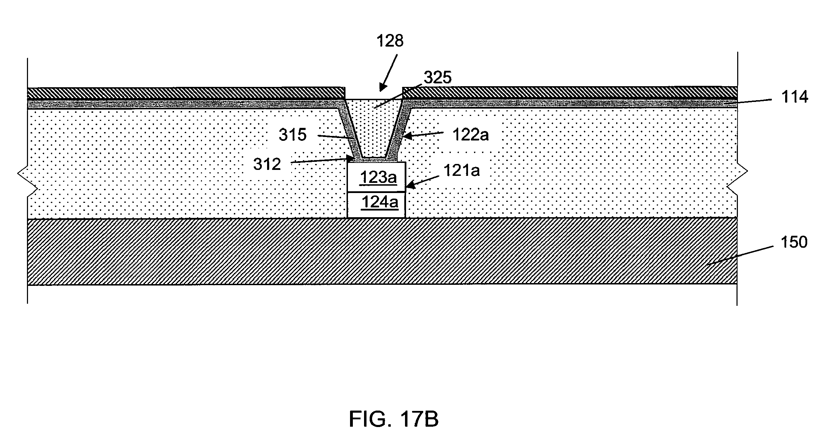

Referring to FIGS. 1-3, a mirror plate 110 can include a reflective layer 111, a spacer layer 113 and a hinge layer 114. In some embodiments, the spacer layer 113 includes a pair of holes 112a and 112b and a pair of openings 108a and 108b. In some embodiments the hinge layer 114 includes two hinge components 120a and 120b. Each hinge component 120a or 120b includes a cavity 125a or 125b in the center. The hinge components 120a and 120b are respectively connected with the main portion of the hinge layer 114 by elongated hinges 163a and 163b. The elongated hinges 163a and 163b are separated from the main portion of the hinge layer 114 by gaps 162a, 162b. The hinge components 120a and 120b are separated from the main portion of the hinge layer 114 by gaps 161. The mirror plate 110 can be tilted about an axis defined by the two hinge components 120a and 120b. In some embodiments, the hinge layer 114 also include two pairs of holes 109a and 109b, respectively, under the holes 112a and 112b in the spacer layer. Each pair of holes 109a or 109b define a bridge 107a or 107b in the hinge layer 114. The bridge 107a or 107b is located under the hole 112a or 112b in the spacer layer 113. As shown in FIGS. 17-21, each bridge 107a or 107b is positioned above a landing stop 140a and 140b on the substrate. Lines A-A, B-B and C-C in FIG. 2 indicate the cross sections for the cross-sectional views in FIG. 5-20.

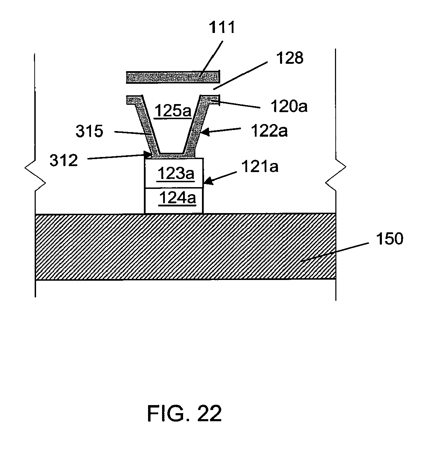

The hinge component 120a (or 120b) is connected to a hinge connection post 122a under the hinge component 120a. As also shown in FIG. 22, the hinge connection post 122a includes a bottom layer 312 and a side layer 315, which define a cavity 125a in the center of the hinge connection post 122a. The cavity 125 can have a circular opening as shown in the FIG. 1-3 or a rectangular opening, such as a square opening. In some embodiment, the side layer 315 can be substantially vertical to the substrate. In embodiments, the side layer 315 has tapered walls. The side layer 315 can be form a cup-like structure in conjunction with the bottom layer 312. In cavities that have a circular opening, the side layer 315 can be conical or have parallel walls. In cavities that have a rectangular opening, the side layer 315 can have tapered wall or walls that are parallel to one another. In embodiments, the hinge connection post has the same shape or cross section as the opening in the hinge component.

The bottom of the hinge connection post 122a is connected to a hinge support post 121a on a substrate. The side layer 315 and the bottom layer 312 can be made of substantially the same material and form a unitary structure. The side layer 315 and the hinge layer 114 can have substantially the same thickness. In some embodiments, the side layer 315 is thinner than the bottom layer 312. The hinge component 120a, 120b and the hinge layer can be formed by a same planar layer (the hinge layer 114). The hinge support post 121a can include an upper portion 123a and a lower portion 124b that can be formed in separate deposition steps.

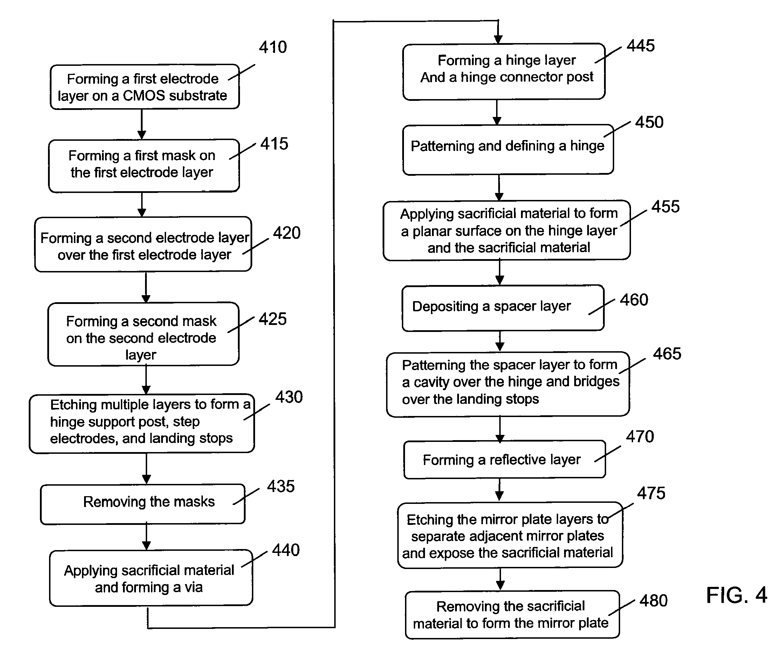

Referring to FIGS. 1,4 and 5, the hinge support posts 121a, 121b, step electrodes 130a, 130b, 131a and 131b and landing stops 140a, 140b are formed on a substrate 150 (steps 410-435). The substrate 150 can include electric circuits connecting to the hinge support posts 121a, 121b, step electrodes 130a, 130b, 131a and 131b and landing stops 140a, 140b. The hinge layer 114 and the hinge connection posts 122a, 122b and the support posts 121a, 121b are formed of an electrically conducting material. Thus, the hinge layer 114 is electrically connected with the hinge support posts 121 a, 121b through the hinge connection posts 122a, 122b. The electric potentials of the hinge layer 114 and the step electrodes 130a, 130b, 131a and 131b can be controlled to produce electric potential difference between the hinge layer 114 and the step electrodes 130a, 131a or the step electrodes 130b, 131b. The resulting electrostatic forces can tilt the mirror plate 110 about an axis defined by the two hinge components 120a and 120b. Details of the steps 410-435 are disclosed in U.S. patent application serial number 11/382,630, entitled "Method for Fabricating a Micro Structure", filed May 10, 2006, which is incorporated by reference herein for all purposes.

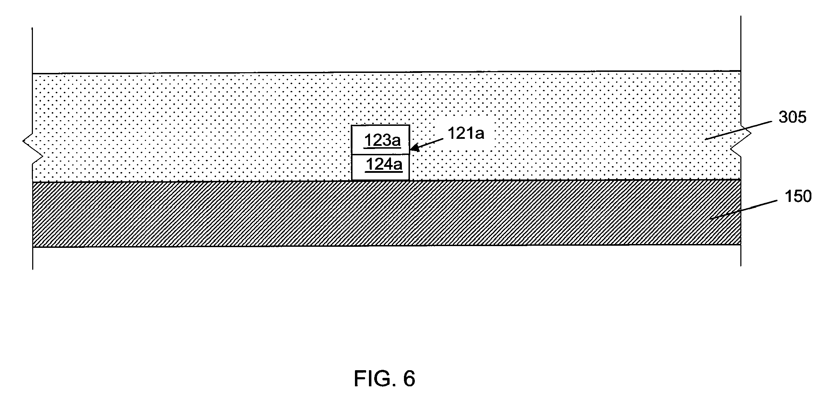

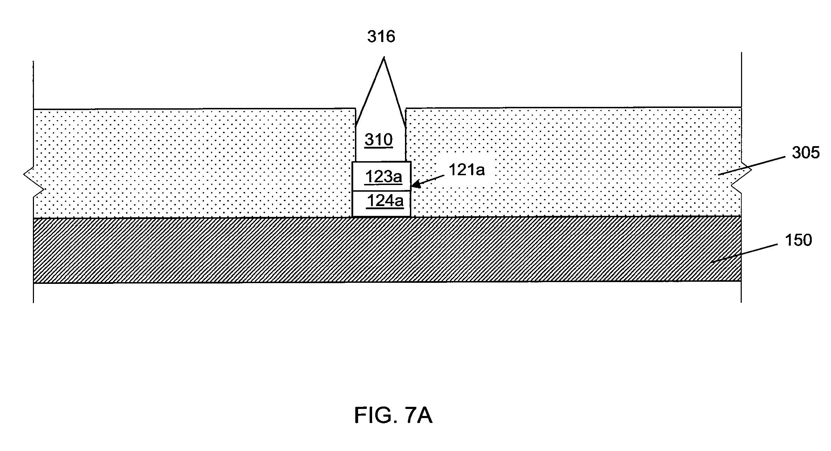

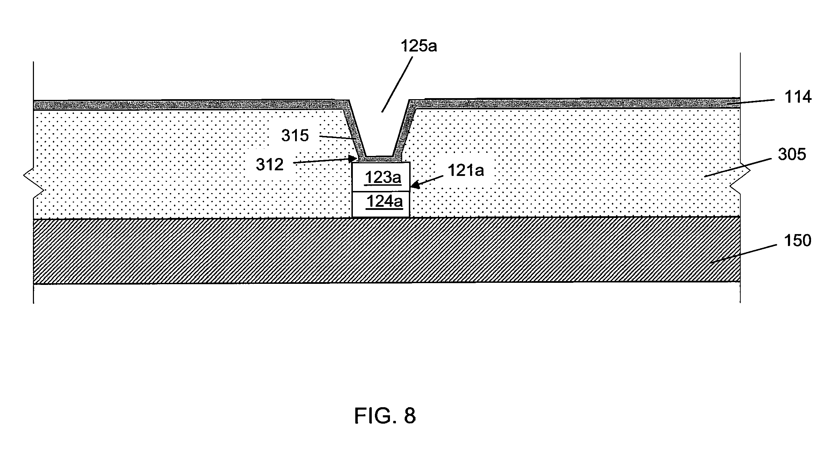

Referring to FIG. 6, a sacrificial material 305 is disposed, for example, by spin-coating, over the substrate 150, the hinge support posts 121a, 121b the step electrodes 130a, 130b, 131a and 131b and landing stops 140a, 140b (step 440). The sacrificial material can include a photo resist material, amorphous carbon, polyarylene, polyarylene ether (which can be referred to as SILK) and hydrogen silsesquioxane (HSQ). After hardening, if required, the sacrificial material 305 can be planarized by chemical mechanical polishing (CMP) to a predetermined height that defines the distance between the lower surface of the hinge layer 114 in the mirror plate 110 and the substrate 150 (see FIGS. 8-22). A via 310 is formed in the sacrificial material 305 over the hinge support posts 121a to expose the upper surface of the hinge support posts 12 1 a (shown in FIG. 7A). The via 310 can have a circular or a rectangular opening.

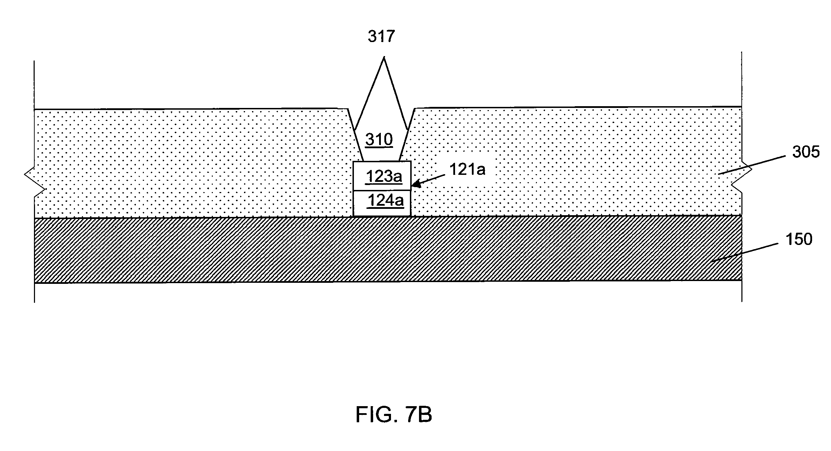

The via 310 initially includes side walls 316 substantially perpendicular to the substrate 150. The substrate 150 having the hinge support posts 121a, 121b and the sacrificial material 305 are then subject to a high temperature treatment to cause the photo resist to over flow to form side walls 317 that are sloped with respect to the substrate 150, as shown in FIG. 7B. In some embodiments, sloped side walls 317 can be formed in the via 310 by anisotropic etching.

An electrically conductive material is next deposited, such as by physical vapor deposition, on the sacrificial material 305 and the upper surface of the hinge support posts 121 a to form the hinge layer 114, as shown in FIG. 8. The deposited electrically conductive material also simultaneously forms one or more side layers 315 and a bottom layer 312 in the via 310 (step 445). The side layers 315 and the bottom layer 312 define a cavity 125a. The hinge connection post 122a is formed by the side layers 315 and the bottom layer 312. Examples of the electrically conductive material include titanium, a titanium-aluminum alloy, a titanium-nickel alloy and an aluminum-copper alloy. The simultaneous formation of the hinge layer 114, the side layers 315 and the bottom layer 312 combines several fabrication steps of other devices into one step and thus simplifies the fabrication of the micro mirror. The mechanical integrity and the strength of the mirror plate 110 are improved because the hinge layer 114, the side layers 315 and the bottom layer 312 are formed in a unitary layer.

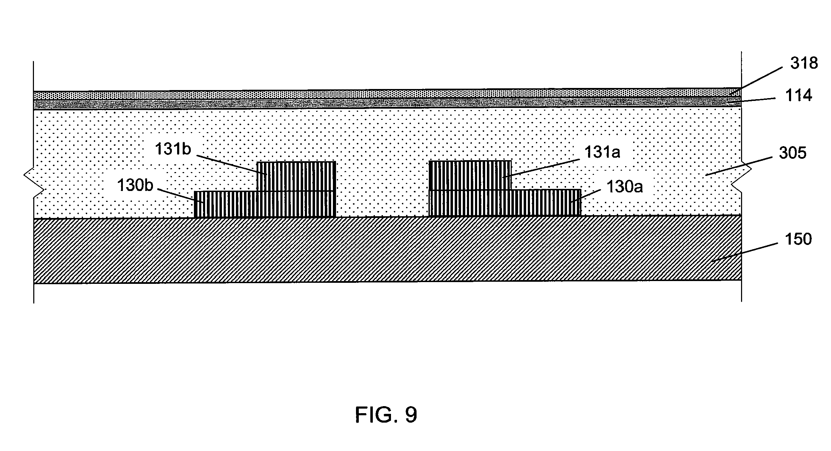

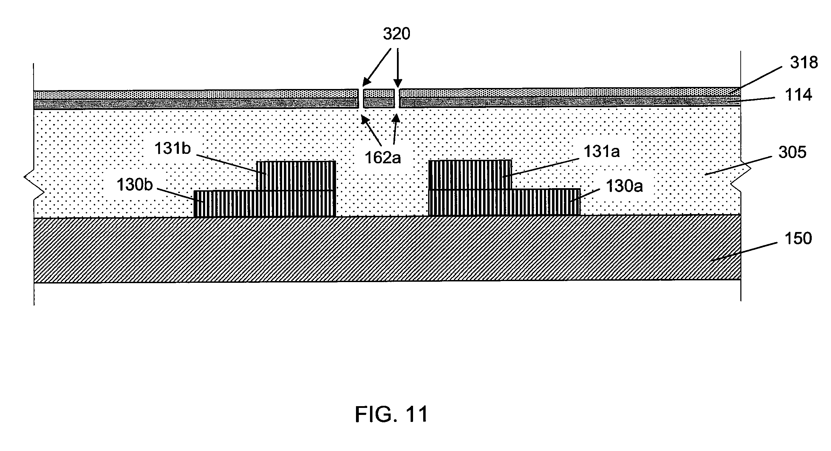

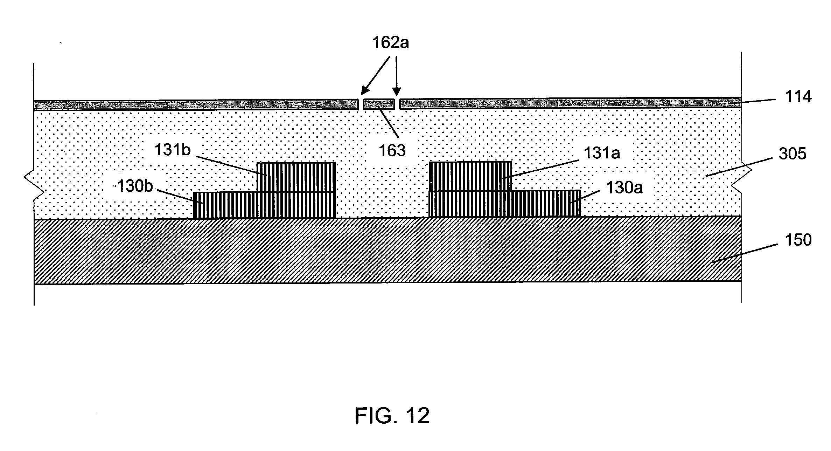

A photo resist layer 318 is then introduced over the hinge layer 114, the side layers 315 and the bottom layer 312, as shown in FIG. 9 (step 450). The photo resist layer 318 is patterned to form two openings 320 to expose the hinge layer 114. The photo resist layer 318 also includes recesses for forming the two pairs of holes 109a and 109b (not shown in FIG. 9). The hinge layer 114 is then etched to form the gaps 162a and the two pairs of holes 109a and 109b in the hinge layer 114 and under the openings 320, as shown in FIG. 11. The sacrificial material 305 is thus exposed in the holes 109a and 109b. The photo resist layer 318 is subsequently removed to define an elongated connection portion 163a in the hinge layer 114, as shown in FIG. 12.

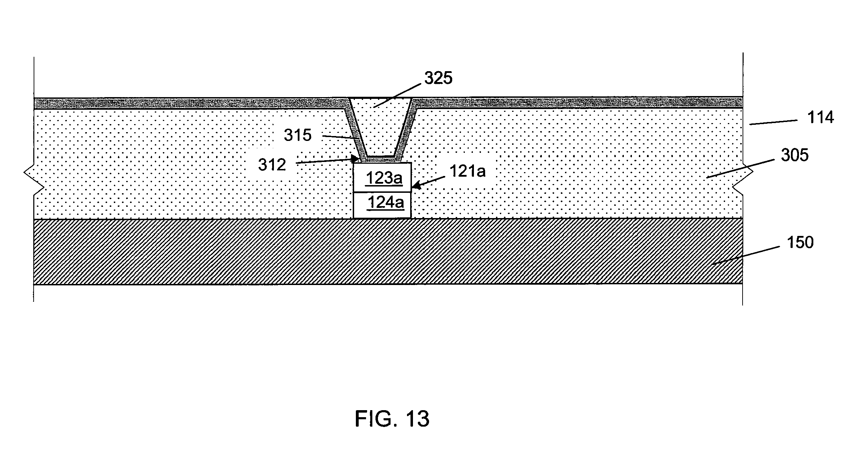

Referring to FIG. 13, a sacrificial material 325 such as a photo resist is disposed to fill the cavity 125a (step 455). The sacrificial material 325 allows a spacer layer 113 to be formed on the cavity 125a and the hinge layer 114 in the subsequent step. The sacrificial material 325 is also disposed on the sacrificial material 305 through the holes 109a and 109b and fills the holes 109a and 109b. The sacrificial material 325 can be spin-coated over the hinge layer and the via 310. The sacrificial material 325 on the hinge layer 114 is subsequently removed. Since a single spin coating may not dispose enough sacrificial material 325 to fill the cavity 125a, several spin coating of the sacrificial material 325 may be applied, each of which can be followed by a removal of the sacrificial material 325 from the top of the hinge layer 114. The upper surface of the sacrificial material 325 is planarized to form a flat surface, that is, at substantially the same height as the upper surface of the hinge layer 114.

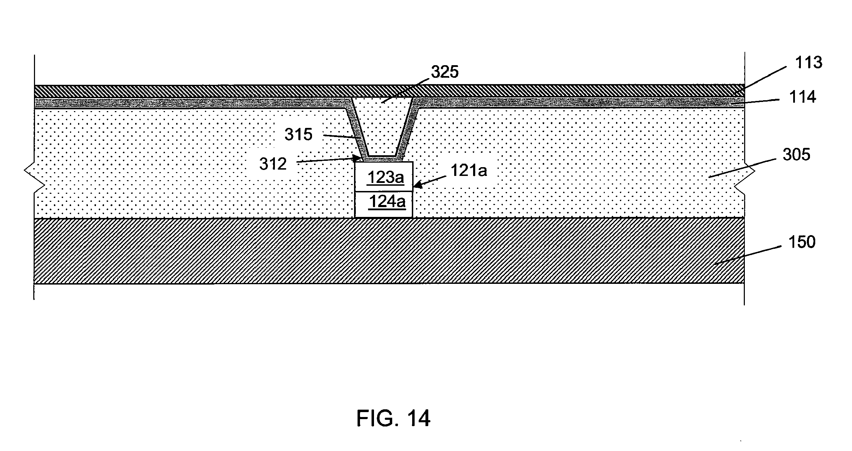

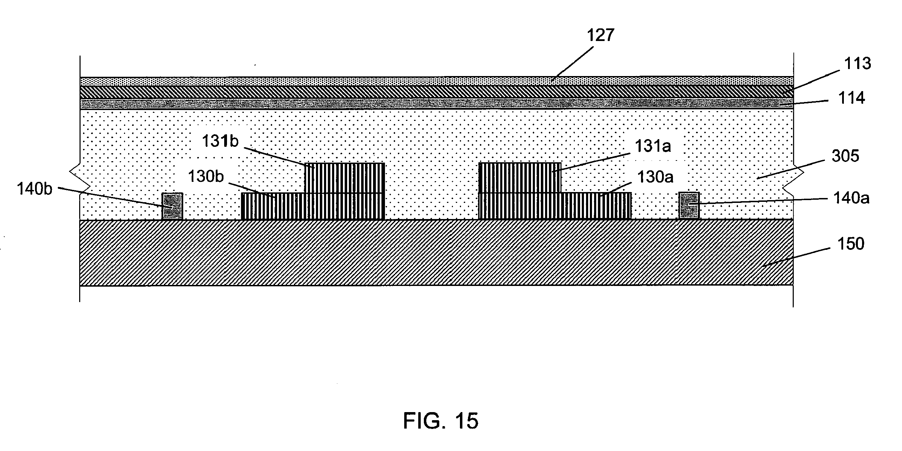

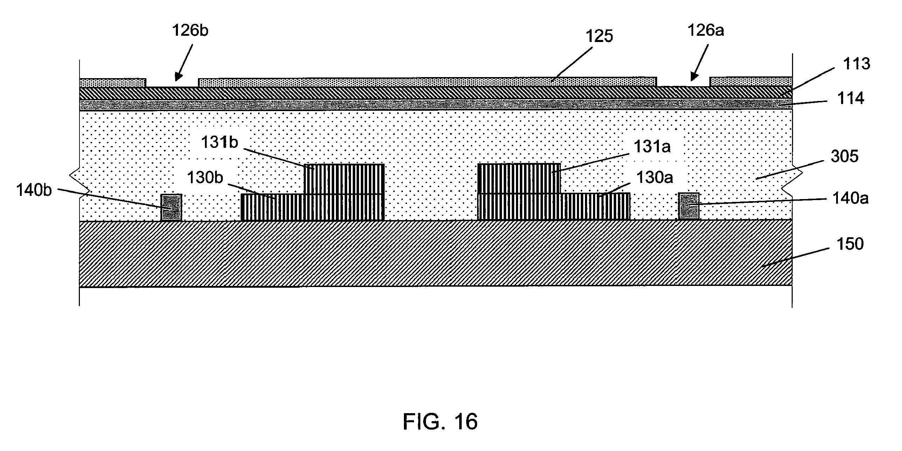

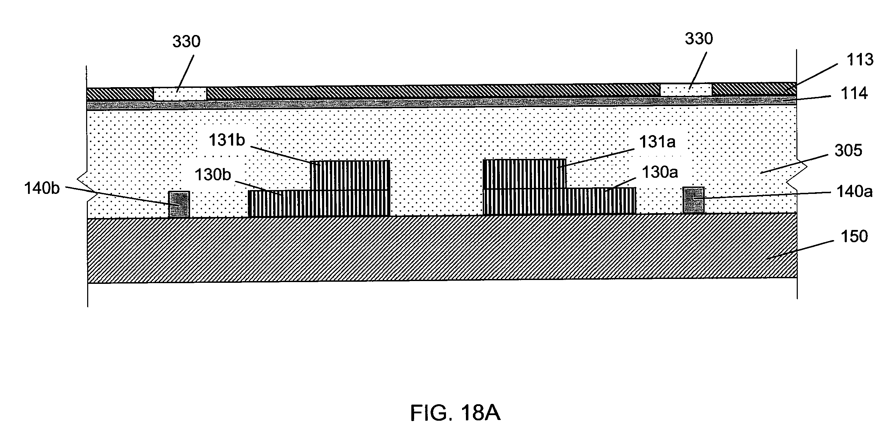

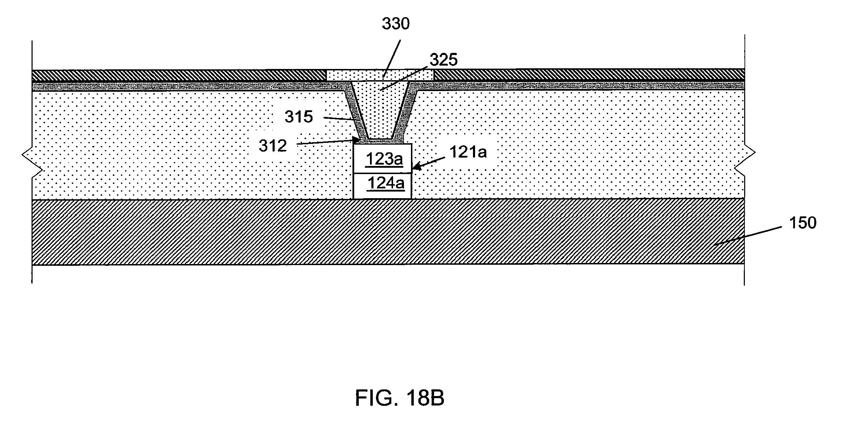

A spacer layer 113 is next deposited on the hinge layer 114, as shown in FIG. 14 (step 460). The spacer layer 113 can be formed for example of amorphous silicon material. A photo resist layer 127 is next spin coated over the spacer layer 113, as shown in FIG. 15 (step 465). The photo resist layer 127 is then patterned to form recesses 126a and 126b to expose the upper surface of the spacer layer 113 above the landing stops 140a, 140b, as shown in FIG. 16. A recess is also formed the photo resist layer 127 over the hinge 113. The spacer layer 113 is then etched in the exposed areas in the recesses 126a and 126b to form the cavities 112a and 112b, as shown in FIG. 17A. The spacer layer 113 is also etched to form a cavity 128 above the hinge component 120a, as shown in FIG. 17B. The cavities 112a and 112b and the two pairs of holes 109a and 109b are then filled with a sacrificial material 330, as shown in FIG. 18A. The cavity 128 is also filled by the sacrificial material 330, as shown in FIG. 18B. The sacrificial material 330 in the holes 109a and 109b contacts the sacrificial material 305 that is between the hinge layer 114 and the substrate 150.

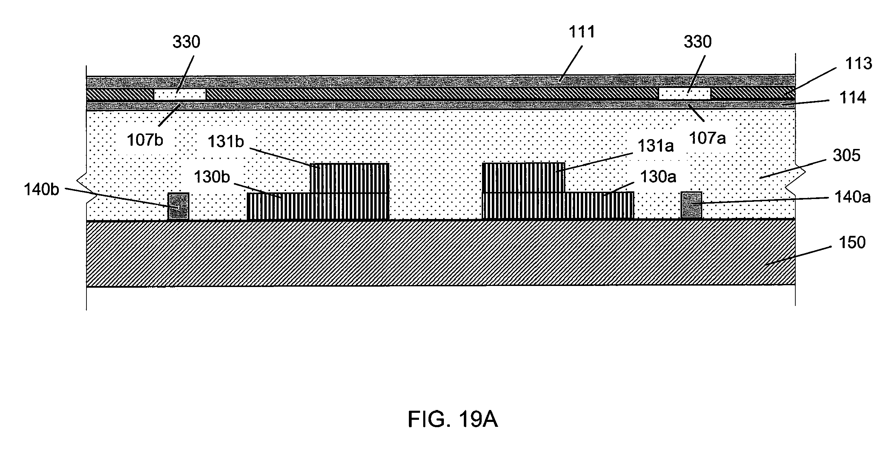

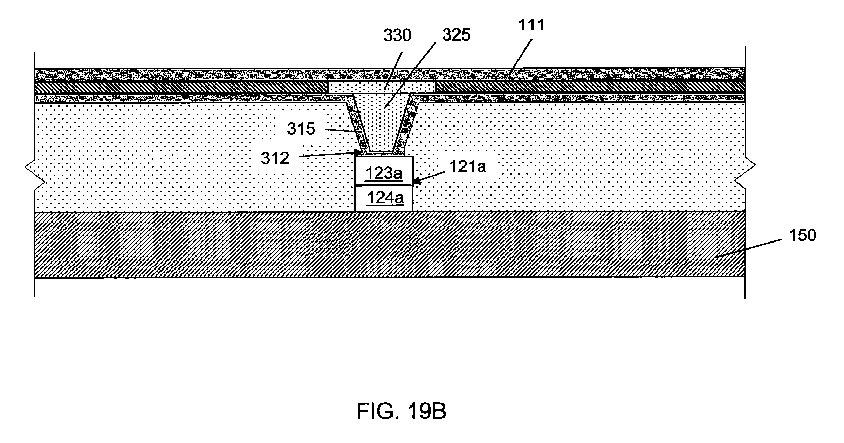

A reflective layer 111 is next deposited on the spacer layer 113 and the sacrificial material 330, as shown in FIGS. 19A, 19B (step 470). Suitable materials for the reflective layer 112 can include gold, aluminum and gold/aluminum alloys.

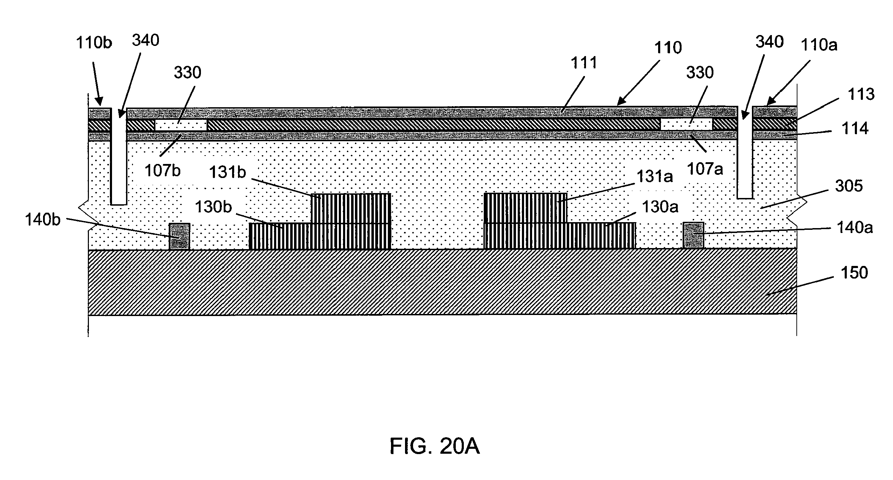

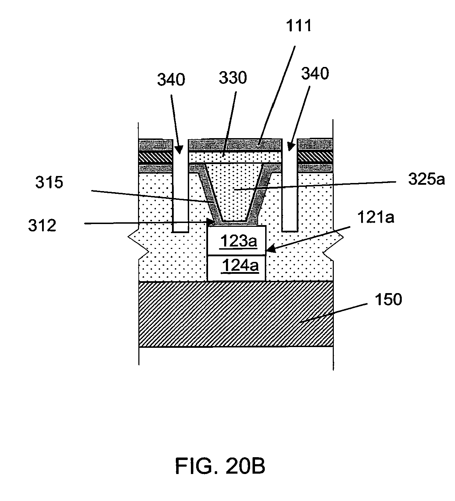

Openings 340 are next formed using photo-resist masking and etching to define the boundaries of each mirror plate 110, as shown in FIGS. 20A, 20B (step 475). That is, the openings 340 separate a mirror plate 110 from its adjacent mirror plates 110a, 110b and expose the sacrificial material 305.

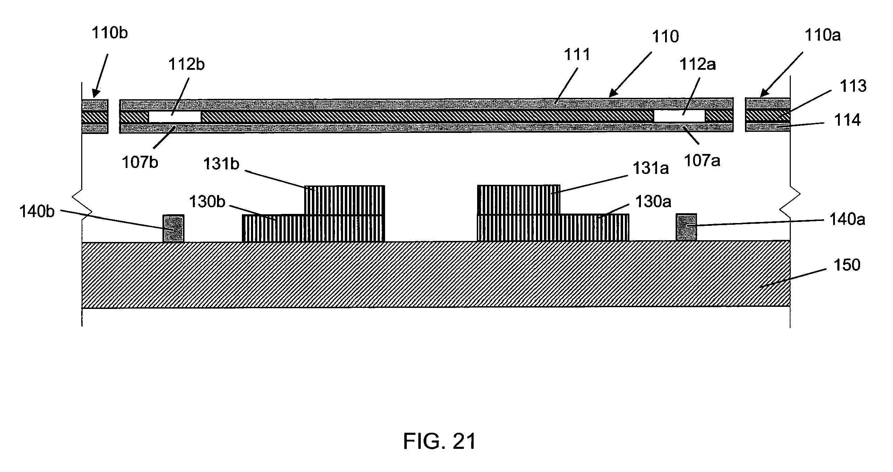

The sacrificial materials 305, 325 and 330 are removed to separate the mirror plate 110 as shown in FIGS. 21a and 22 (step 480). The mirror plate 100 includes the reflective layer 111, the spacer layer 113 and the hinge layer 114. The hinge connection posts 122a and 122b, each of which includes one or more side layers 315, a bottom layer 312 and a cavity 125a or 125b in the center. The hinge component 120a is connected to the side layer 315 of the hinge connection post 122a. The hinge connection post 122a is further connected to the hinge support post 121a on the substrate 150. The hinge layer 114, the hinge connection posts 122a, 122b and the hinge support posts 121a, 121b are electrically conductive to allow the electric potential of the hinge layer 114 to be controlled by an electric circuit in the substrate 150.

The mirror plate 110 can tilt about an axis defined by the hinge components 120a, 120b under an electrostatic torque produced by an electric potential difference between the hinge layer 114 and the electrode 130a-131b on the substrate 150. The tilt movement of the mirror plate 110 can be stopped when the bridge 107a or 107b comes to contact with a landing stop 140a or 140b. The landing stops 140a and 140b can define the mirror plate 110 at precise tilt angels at which the reflective layer 111 can reflect an incident light in a predetermined direction. The electrostatic force can produce a distortion in the bridge 107a or 107b. The stored elastic energy can be released to help the separation of the mirror plate 110 from the landing stop 107a or 107b when the electrostatic force is removed or reversed.

In some embodiments, the dimensions of the micro mirrors are as follow. The hinge component 120a, 120b can be about 2-7 µm long, about 0.2-0.6 µm wide and about 0.04-0.1 µm thick. The hinge support posts 121a, 121b can be about 0.5-1.1 µm wide and 1-2 µm high. The landing stops 140a, 140b can be 0.5-2.0 µm high and 0.2-0.6 µm wide. The electrodes 130a, 130b can be 0.2-0.5 µm high. The step electrodes 131a, 131b can be 0.5-1.0 µm in height. The reflective layer 111 can be 500 angstroms or less in thickness.

It is understood that the disclosed methods are compatible with other configurations of micro mirrors. Different material from described above can be used to form the different layers of the mirror plate, the hinge connection post, the hinge support post, the electrodes and the landing stops. The electrodes can include steps as shown in the figures, or an upper surface at a single height. The mirror plate can also have different shapes such as a hexagon, a diamond and an octagon.

## Claims

1. A micro mirror, comprising:
a hinge connection post supported by a substrate, wherein the hinge connection post comprises a bottom layer and a side layer surrounding a cavity in the center of the hinge connection post;
a hinge component connected to the side layer of the hinge connection post; and
a mirror plate configured to tilt around the hinge component.

2. The micro mirror of claim 1, wherein the side layer is sloped relative to the substrate.

3. The micro mirror of claim 1 or 2, wherein the side layer is cone shaped, and the side layer and the bottom layer form a cup-like structure.

4. The micro mirror of one of the preceding claims, wherein the side layer, the bottom layer and the hinge component form a unitary structure.

5. The micro mirror of one of the preceding claims, wherein the side layer, the bottom layer and the hinge component are made of substantially the same material.

6. The micro mirror of one of claims 1, 4 or 5, wherein the side layer is substantially vertical to the substrate.

7. The micro mirror of one of the preceding claims, wherein the mirror plate comprises a reflective layer and a hinge layer.

8. The micro mirror of claim 7, wherein the hinge connection post, the hinge component and the hinge layer form a unitary structure.

9. The micro mirror of claim 7 or 8, wherein the hinge component and the hinge layer are co-planar.

10. The micro mirror of one of claims 7 to 9, wherein the hinge connection post, the hinge component and the hinge layer are made of substantially the same material.

11. The micro mirror of one of claims 7 to 10, wherein the hinge connection post, the hinge component and the hinge layer comprise an electrically conductive material.

12. A method for fabricating a mirror plate over a substrate, comprising:
forming a hinge support post on the substrate;
forming a hinge connection post on the hinge support post and a hinge layer connected to the hinge connection post simultaneously;
forming a reflective layer over the hinge layer; and
selectively removing portions of the reflective layer and the hinge layer to form the mirror plate and a hinge component that is connected to the hinge connection post and the hinge layer, wherein the mirror plate is configured to tilt around the hinge component.

13. The method of claim 12, wherein the step of forming a hinge connection post comprises:
disposing a sacrificial material on the substrate and the hinge support post;
forming a via in the sacrificial material to expose an upper surface of the hinge support post; and
depositing an electrically conductive material to simultaneously form the hinge connection post in the via and the hinge layer on the sacrificial material.

14. The method of claim 13, wherein the via comprises a surface that is sloped relative to the substrate.

15. The method of claim 13, wherein the via comprises a surface that is substantially vertical to the substrate.

16. The method of one of claims 12 to 14, wherein the hinge connection post comprises a bottom layer and a cone-shaped side layer, wherein the lower edge of the cone-shaped side layer is connected to the bottom layer to define a cavity.

17. The method of one of claims 12 to 16, wherein the hinge component and the hinge layer are co-planar.

18. The method of one of claims 12 to 17, wherein the hinge connection post, the hinge component and the hinge layer comprise an electrically conductive material.

19. The method of claim 12, further comprising:
disposing a sacrificial material on the substrate and the hinge support post;
forming a via in the sacrificial material to expose an upper surface of the hinge support post;
wherein the step of forming the hinge connection post includes depositing an electrically conductive material to simultaneously form a hinge connection post in the via and the hinge layer on the sacrificial material;
selectively removing the electrically conductive material in the hinge layer to form openings in the hinge layer to define a hinge component in the hinge layer and over the hinge connection post;
forming a spacer layer on the hinge layer and the hinge component; and
wherein the step of selectively removing portions of the reflective layer includes exposing the sacrificial material and removing the sacrificial material to form the mirror plate and the hinge component connected to the hinge connection post and the hinge layer.
